# EUROPEAN PATENT APPLICATION

(11) **EP 4 764 568 A1**
(43) Date of publication of application: **24.06.2026**
(21) Application number: 25809993.6
(22) Date of filing: 21.02.2025
(51) Int. Cl.: G01R 31/396, G01R 31/389, G01R 31/392, G01R 31/382, G01R 31/371

(54) **BATTERY MANAGEMENT DEVICE AND BATTERY MANAGEMENT METHOD**

(30) Priority: 09.05.2024 KR 20240061441
(71) Applicant: LG Energy Solution, Ltd., Seoul 07335 (KR)
(72) Inventor: CHOI, Yean Sik, Daejeon 34122 (KR); LEE, Jung Hoon, Daejeon 34122 (KR); LEE, Byung Kyu, Daejeon 34122 (KR)
(74) Representative: Plasseraud IP
(86) International application number: PCT/KR2025/002458
(87) International publication number: WO 2025/234572

(57) **Abstract**

The present invention relates to a lithium secondary battery, and more specifically to a lithium secondary battery having a multi-directional lead-tab structure. The lithium secondary battery of the present invention includes: an electrode assembly which is formed by alternately laminating an electrode plate having a current collector, an active material, and a tab, and an isolation layer; a lead which is electrically connected to the tab; and a battery case, wherein the lead is divided into an anode lead and a cathode lead, and at least two or more anode leads and cathode leads are provided. The battery of the present invention uses the same lead-tab size as the prior art and is suitable for use with high current.

## Description

### TECHNICAL FIELD

### Cross-reference to Related Applications

This application claims priority from Korean Patent Application No. 10-2024-0061441, filed on May 9, 2024, the disclosure of which is incorporated by reference herein.

### Technical Field

Embodiments disclosed in this document relate to a battery management device and a battery management method.

### BACKGROUND ART

Recently, research and development on secondary batteries have been actively conducted. Here, secondary batteries are batteries that can be charged and discharged, and may be interpreted including both conventional Ni/Cd batteries, Ni/MH batteries, and recent lithium ion batteries. Among secondary batteries, lithium ion batteries may have much higher energy density than conventional Ni/Cd batteries, Ni/MH batteries, etc. and may be manufactured to be small and lightweight, and thus lithium ion batteries may have high usability as a power source for mobile devices. Recently, the scope of use of the lithium ion batteries has expanded to include a power source for electric vehicles, and the lithium ion batteries are attracting attention as a next-generation energy storage medium.

A structure of a multi-pack battery that includes one traction battery pack and one or more extender battery packs may be utilized to provide power for an electric vehicle. An internal resistance value of a battery pack may be needed to estimate a state of health (SOH) of the battery pack. The internal resistance may be measured by measuring and analyzing an electrical response, such as current or voltage, during a charge and discharge process of the battery pack. When only a single battery pack is used, a separate charge and discharge device that provides charge and discharge inputs having a predetermined pattern may be needed to measure the internal resistance.

### DISCLOSURE OF THE INVENTION

### TECHNICAL PROBLEM

Embodiments disclosed in this document may provide a battery management device and a battery management method that can improve a method of measuring the internal resistance of the battery pack using the multi-pack structure.

The technical objectives of the embodiments disclosed in this document are not limited to the technical problems mentioned above, and other technical problems not mentioned can be clearly understood by those skilled in the art from the descriptions below.

### TECHNICAL SOLUTION

According to some embodiments, a battery management device includes a data acquisition unit configured to acquire battery data from a multi-pack battery including a main battery pack and one or more sub-battery packs and a control unit configured to select an auxiliary battery pack among the remaining battery packs excluding a target battery pack from the multi-pack battery based on the battery data, apply a target charge and discharge profile to the target battery pack by distributing charge and discharge input to the target battery pack and the auxiliary battery pack, and calculate an internal resistance of the target battery pack based on an electrical response of the target battery pack to the target charge and discharge profile.

According to some embodiments, the control unit is configured to generate a charge current profile for the target battery pack by distributing a charge current to the target battery pack and the auxiliary battery pack and generate a discharge current profile for the target battery pack by distributing a discharge current to the target battery pack and the auxiliary battery pack.

According to some embodiments, the control unit is configured to generate the charge and discharge input based on whether a battery charger is connected to the multi-pack battery.

According to some embodiments, the control unit is configured to generate the charge and discharge input based on a charge and discharge of the battery charger when the battery charger is connected to the multi-pack battery.

According to some embodiments, the control unit is configured to select a source battery pack among the remaining battery packs excluding the target battery pack and the auxiliary battery pack from the multi-pack battery based on the battery data when the battery charger is not connected to the multi-pack battery and generate the charge and discharge input based on the charge and discharge of the source battery pack.

According to some embodiments, the control unit is further configured to correct a state of health (SOH) of the target battery pack based on the internal resistance.

According to some embodiments, the control unit is configured to initiate a calculation process of the internal resistance when there is a user manual setting, transmit a suggestion message to the user terminal based on a timer regarding an unused time of the multi-pack battery when there is no user manual setting, and initiate a calculation process of the internal resistance when there is a user agreement on the suggestion message.

According to some embodiments, a battery management method includes acquiring battery data from a multi-pack battery including a main battery pack and one or more sub-battery packs, selecting an auxiliary battery pack among the remaining battery packs excluding a target battery pack from the multi-pack battery based on the battery data, applying a target charge and discharge profile to the target battery pack by distributing charge and discharge input to the target battery pack and the auxiliary battery pack, and calculating an internal resistance of the target battery pack based on an electrical response of the target battery pack to the target charge and discharge profile.

According to some embodiments, the applying of the target charge and discharge profile includes generating a charge current profile for the target battery pack by distributing a charge current to the target battery pack and the auxiliary battery pack and generating a discharge current profile for the target battery pack by distributing a discharge current to the target battery pack and the auxiliary battery pack.

According to some embodiments, the applying of the target charge and discharge profile includes generating the charge and discharge input based on whether a battery charger is connected to the multi-pack battery.

According to some embodiments, the applying of the target charge and discharge profile includes generating the charge and discharge input based on a charge and discharge of the battery charger when the battery charger is connected to the multi-pack battery.

According to some embodiments, the applying of the target charge and discharge profile includes selecting a source battery pack among the remaining battery packs excluding the target battery pack and the auxiliary battery pack from the multi-pack battery based on the battery data when the battery charger is not connected to the multi-pack battery and generating the charge and discharge input based on the charge and discharge of the source battery pack.

According to some embodiments, the battery management method further includes correcting a state of health (SOH) of the target battery pack based on the internal resistance.

According to some embodiments, the calculating of the internal resistance includes initiating a calculation process of the internal resistance when there is a user manual setting, transmitting a suggestion message to the user terminal based on a timer regarding an unused time of the multi-pack battery when there is no user manual setting, and initiating a calculation process of the internal resistance when there is a user agreement on the suggestion message.

### ADVANTAGEOUS EFFECTS

According to the embodiments disclosed in this document, a battery management device and a battery management method which can improve a method of measuring internal resistance of a battery pack by using a multi-pack structure can be provided.

Technical effects according to the embodiments disclosed in this document are not limited to the effects mentioned above, and other effects not mentioned will be clearly understood by those skilled in the art according to the disclosure of this document.

### BRIEF DESCRIPTION OF THE DRAWINGS

FIG. 1 illustrates components constituting a battery management system according to some embodiments.
FIG. 2 illustrates components constituting a battery management device according to some embodiments.
FIG. 3 illustrates a structure of a multi-pack battery according to some embodiments.
FIG. 4 illustrates a process of starting a task of calculating an internal resistance of a battery pack in a multi-pack battery according to some embodiments.
FIG. 5 illustrates a process of calculating the internal resistance by selecting a source battery pack according to some embodiments.
FIG. 6 illustrates a method of applying a charge current profile to a target battery pack using an auxiliary battery pack according to some embodiments.
FIG. 7 illustrates a method of applying a discharge current profile to a target battery pack using an auxiliary battery pack according to some embodiments.
FIG. 8 illustrates steps constituting a battery management method according to some embodiments.

### MODE FOR CARRYING OUT THE INVENTION

Hereinafter, embodiments described in this document are described with reference to the accompanying drawings. However, this is not intended to limit the disclosure of this document to a specific embodiment, but should be understood to include various modifications, equivalents, and/or alternatives of the embodiments described in this document.

Embodiments of this document and the terms used therein are not intended to limit the technical features described in this document to a specific embodiment, but should be understood to include various modifications, equivalents, or alternatives of the embodiment. In connection with the description of the drawings, similar reference numerals may be used for similar or related components. The singular form of a noun corresponding to an item may include one or more of said items, unless the context clearly indicates otherwise.

In this document, each of phrases "A or B", "at least one of A and B", "at least one of A or B", "A, B, or C", "at least one of A, B, and C", and "at least one of A, B, or C" may include any one of the items listed together in that phrase, or all possible combinations thereof. Terms such as "first", "second", "firstly", "secondly", "A", "B", "(a)", or "(b)" may be used merely to distinguish one component from another, and do not limit the components in any other respect (e.g., importance or order) unless specifically stated otherwise.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner or wirelessly), or indirectly (through a third component).

The method according to various embodiments disclosed in this document may be provided by being included in a computer program product. The computer program product may be traded between a seller and a buyer as a product. The computer program product may be distributed in the form of a machine-readable storage medium (e.g., compact disc read only memory (CD-ROM)), or may be distributed online (e.g., downloaded or uploaded) through an application store or directly between two user devices. In the case of online distribution, at least a part of the computer program product may be temporarily stored or temporarily generated in a machine-readable storage medium such as a memory of a manufacturer's server, an application store's server, a relay server.

According to the embodiments disclosed in this document, each of the components (e.g., modules or programs) described above may include a single or plurality of entities, and some of the plurality of entities may be separated and placed in other components. According to the embodiments disclosed in this document, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to the embodiments disclosed in this document, the operations performed by a module, program, or other component may be performed sequentially, in parallel, repeatedly, or heuristically, or one or more of the operations may be performed in a different order, omitted, or performed by being added with one or more other operations.

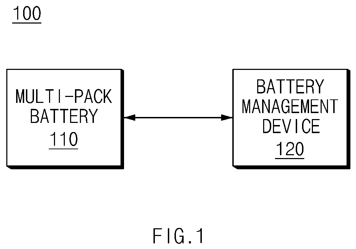

FIG. 1 illustrates components that constitute a battery management system according to some embodiments.

Referring to FIG. 1, a battery management system 100 may include a multi-pack battery 110 and a battery management device 120. However, the present invention is not limited thereto, and some components may be omitted from the battery management system 100, or other general-purpose configurations may be further included in the battery management system 100.

The multi-pack battery 110 may include a plurality of battery packs. The multi-pack battery 110 may include a main battery pack and one or more sub-battery packs. The main battery pack may be a traction battery pack, and the sub-battery pack may be an extender battery pack. The multi-pack battery 110 may be used by a power-using apparatus. The power-using apparatus may include a mobility apparatus such as an electric vehicle (EV), a hybrid electric vehicle (HEV), or an electric bike.

The battery management device 120 can manage a state of the multi-pack battery 110. In order to properly manage the battery packs of the multi-pack battery 110, it may be necessary to accurately calculate a state of health (SOH) of each battery pack. Since internal resistance of the battery pack is used in a calculation process of SOH, it may be desirable to correct the SOH value by updating the internal resistance to the latest value. Since the multi-pack battery 110 includes two or more battery packs, a process for calculating the internal resistance of each battery pack may be performed using the battery packs.

In the case of a single battery pack, a separate battery charger providing a specific charge and discharge pattern may be required to measure the internal resistance. On the other hand, the multi-pack battery 110 may treat one of a plurality of battery packs as a battery charger and generate charge and discharge input. In addition, the multi-pack battery 110 may be able to independently generate a charge and discharge pattern necessary for measuring the internal resistance by distinguishing between a target pack and an auxiliary pack.

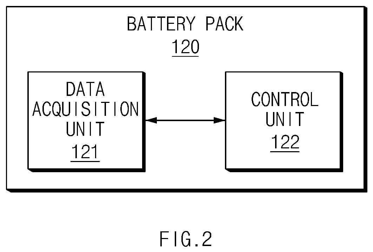

FIG. 2 illustrates components that constitute a battery management device according to some embodiments.

Referring to FIG. 2, the battery management device 120 may include a data acquisition unit 121 and a control unit 122. However, the present invention is not limited thereto, and some configurations may be omitted from the battery management device 120, or other general-purpose configurations may be further included in the battery management device 120.

The data acquisition unit 121 may include a sensor unit and/or a communication unit. The sensor unit may directly measure battery data from the multi-pack battery 110, and the communication unit may receive battery data of the multi-pack battery 110 measured externally from the battery management device 120. For example, when the battery management device 120 is configured together with the multi-pack battery 110 in the form of an on-board BMS, the data acquisition unit 121 may include a sensor unit. Alternatively, when the battery management device 120 is an external device remotely placed in an off-board form of the multi-pack battery 110, the data acquisition unit 121 may include a communication unit. The external device may include a battery charger, a battery management server, etc. According to the embodiment, the battery management server may be implemented in a cloud computing environment.

The control unit 122 may include a memory and/or a processor. The processor may be implemented in the form of at least one of a logic gate array, a microprocessor, a CPU, a GPU, and an AP. The memory may be implemented as a nonvolatile device such as a ROM, a PROM, an EPROM, an EEPROM, a flash memory, a PRAM, a MRAM, a RRAM, a FRAM, etc., or a volatile device such as a DRAM, SRAM, SDRAM, PRAM, etc., and may be implemented in the form of an HDD, an SSD, an SD, a Micro-SD, etc., or a combination thereof.

The data acquisition unit 121 may be configured to acquire battery data from the multi-pack battery 110 including a main battery pack and one or more sub-battery packs. For example, the data acquisition unit 121 may measure battery data directly from the multi-pack battery 110 through the sensor unit, or may receive battery data of the multi-pack battery 110 through the communication unit.

The control unit 122 may be configured to select the auxiliary battery pack among the remaining battery packs excluding the target battery pack in the multi-pack battery 110 based on battery data. The target battery pack may be selected as a battery pack for which SOH calculation and/or correction is required. For example, all battery packs of the multi-pack battery 110 may be sequentially selected as target battery packs once. Alternatively, a battery pack in a situation where an accurate SOH value is required, such as state of charge (SOC) estimation, may be selected as the target battery pack. The auxiliary battery pack may be involved in charge and discharge operations, and may be selected based on various battery state values. For example, the auxiliary battery pack may be selected based on a SOH value and a SOC value. For example, among the remaining battery packs except for the target battery pack, a battery pack having the highest SOH may be selected as the auxiliary battery pack, and in the case of the same SOH, a battery pack having a lower SOC may be selected as the auxiliary battery pack.

The control unit 122 may be configured apply a target charge and discharge profile to the target battery pack by distributing the charge and discharge input to the target battery pack and the auxiliary battery pack. The charge and discharge input may include a charge voltage input, a discharge voltage input, a charge current input, a discharge current input, etc. utilized for charge and discharge of the target battery pack. The target charge and discharge profile may include a specific current pattern and/or voltage pattern configured to measure the internal resistance of the target battery pack. The charge and discharge input may be dynamically distributed to the target battery pack and the auxiliary battery pack to apply the target charge and discharge profile to the target battery pack. According to the embodiment, the target charge and discharge profile may include current pulses or voltage pulses that gradually increase or decrease linearly.

The control unit 122 may be configured to calculate the internal resistance of the target battery pack based on an electrical response of the target battery pack to the target charge and discharge profile. When the target charge and discharge profile is applied to the target battery pack, the target battery pack may output an electrical response thereto. For example, when the target charge and discharge profile is current pulses, the electrical response of the target battery pack may be response voltage values, and the internal resistance of the target battery pack may be calculated based on the current pulse values and the response voltage values. The internal resistance value may be used to estimate a more accurate battery state of the target battery pack.

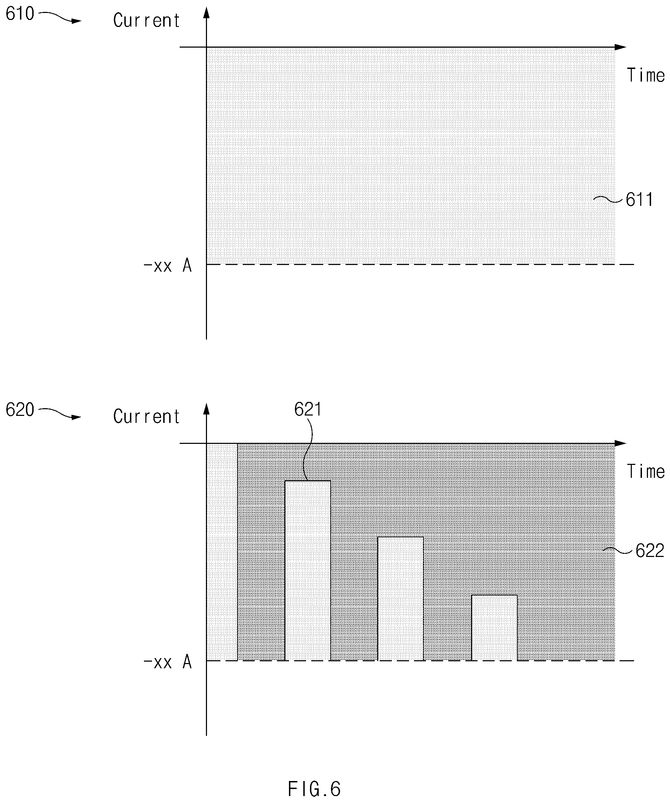

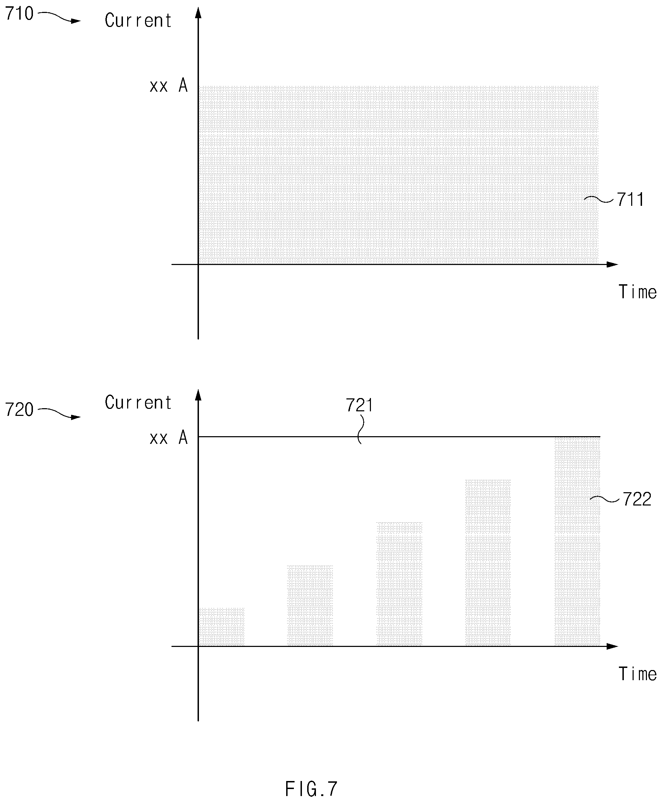

According to the embodiment, the control unit 122 may be configured to generate a charge current profile for the target battery pack by distributing the charge current to the target battery pack and the auxiliary battery pack, and generate a discharge current profile for the target battery pack by distributing the discharge current to the target battery pack and the auxiliary battery pack. The charge and discharge input may include charge and discharge current, charge and discharge voltage, etc. Preferably, the charge and discharge current may be utilized, and the charge current profile and the discharge current profile may be generated by distributing the charge and discharge current to the target battery pack and the auxiliary battery pack. For example, the charge current profile and the discharge current profile may include current pulses that gradually increase or decrease linearly, as illustrated in FIGS. 6 and 7 described below.

According to the embodiment, the control unit 122 may be configured to generate the charge and discharge input based on whether the battery charger is connected to the multi-pack battery 110. The charge and discharge input that serves as the basis for generating the target charge and discharge profile may be provided externally from outside the target battery pack. A provider of the charge and discharge input may be a battery charger external to the multi-pack battery 110, or may be another battery pack internal to the multi-pack battery 110. The structure of the multi-pack battery 110 may have an advantage over a single battery pack in that charge and discharge input can be generated from the internal battery pack.

According to the embodiment, the control unit 122 may be configured to generate the charge and discharge input based on the charge and discharge of the battery charger when the battery charger is connected to the multi-pack battery 110. For example, the battery charger may provide a constant value of charge current and/or discharge current, and the charge and discharge current profile may be generated through current distribution control for the same. In the case of a single battery pack, the battery charger should directly generate the charge and discharge current profile and provide it to the target battery pack, whereas in the case of the multi-pack battery 110, the battery charger may only provide a constant current value, and the charge and discharge current profile may be generated through current distribution to the target battery pack and the auxiliary battery pack.

According to the embodiment, the control unit 122 may be configured to select a source battery pack among the remaining battery packs in the multi-pack battery 110 excluding the target battery pack and the auxiliary battery pack based on the battery data from the multi-pack battery 110 when the battery charger is not connected to the multi-pack battery 110, and generate the charge and discharge input based on charge and discharge of the source battery pack. For example, the source battery pack may provide a constant value of charge current and/or discharge current, and the charge and discharge current profile may be generated through current distribution control for the same. When the source battery pack is utilized, the charge and discharge input may be generated even when there is no battery charger. This may be an advantage of the multi-pack battery 110 that cannot be achieved with a structure of the single battery pack structure. The source battery pack may be selected based on state values such as the SOH and SOC of the battery packs.

According to the embodiment, the control unit 122 may be further configured to correct the state of health (SOH) of the target battery pack based on the internal resistance. The internal resistance value calculated based on the electrical response to the application of the charge and discharge profile may be the latest internal resistance value of the current target battery pack. Therefore, acquiring the SOH value using the latest value may lead to more accurate results compared to the case of using the past internal resistance value. According to the embodiment, in addition to the SOH value, other battery state index values calculated using the internal resistance of the battery pack may also be corrected or updated.

According to the embodiment, the control unit 122 may be configured to initiate a calculation process of the internal resistance when there is a user manual setting, transmit a suggestion message to a user terminal based on a timer regarding the unused time of the multi-pack battery 110 when there is no user manual setting, and initiate the calculation process of the internal resistance when there is a user agreement on the suggestion message. It may be considered first whether the user manually instructs to calculate the internal resistance, and when there is no user manual setting, a timer-based suggestion message may be sent. The unused time may be counted based on the end point in time of use of the multi-pack battery 110 or the end point in time of operation of the mobility apparatus.

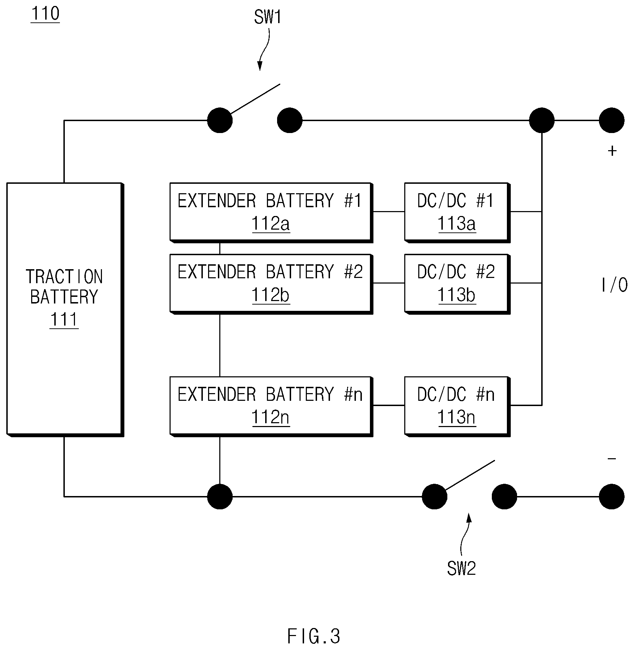

FIG. 3 illustrates a structure of a multi-pack battery according to some embodiments.

Referring to FIG. 3, the multi-pack battery 110 may include a traction battery 111 and one or more extender batteries 112a to 112n. One or more DC-DC converters 113a to 113n may be connected to one or more extender batteries 112a to 112n. The traction battery 111 may correspond to the main battery pack, and one or more extender batteries 112a to 112n may correspond to one or more sub-battery packs.

The control unit of the battery management device 120 and/or the multi-pack battery 110 may control a first switch SW1 and a second switch SW2, etc. to select a battery pack connected to an input/output port I/O. For example, the opening and closing of switches of the multi-pack battery 110 may be controlled to transfer power from the discharge battery pack to the charge battery pack.

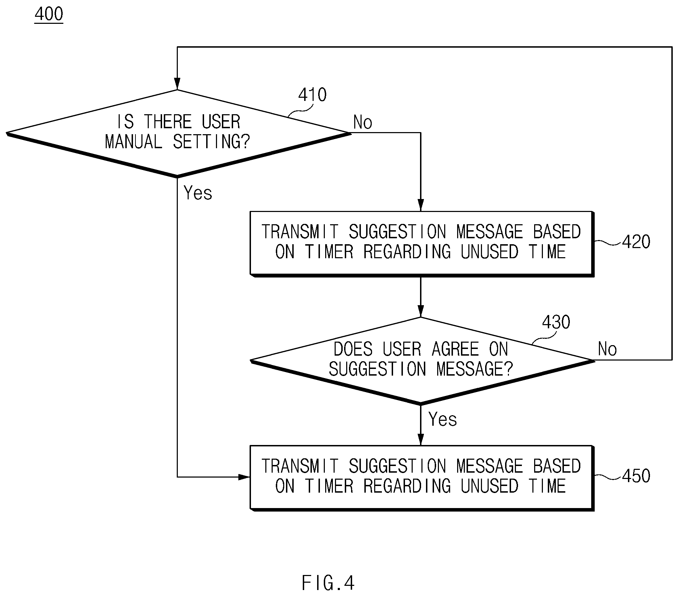

FIG. 4 illustrates a process of starting a task of calculating internal resistance of a battery pack in a multi-pack battery according to some embodiments.

Referring to FIG. 4, a flow 400 illustrating a process of starting the task of calculating the internal resistance of the battery pack in the multi-pack battery 110 may be illustrated.

In step 410, it may be determined whether there is a user manual setting that instructs calculation of the internal resistance. The user may be a user of the multi-pack battery 110 or a mobility apparatus. When there is the user manual setting, processes for calculating the internal resistance may be performed in step 450.

When there is no user manual setting, a timer may be operated based on the unused time of the multi-pack battery 110 and/or the mobility device and a suggestion message may be transmitted to the user terminal when the reference time elapses, in step 420. In step 430, it may be determined whether the user agrees on the suggestion message. When there is agreement, processes for calculating internal resistance may be performed in step 450. When there is no agreement, the flow 400 may return to the initial step.

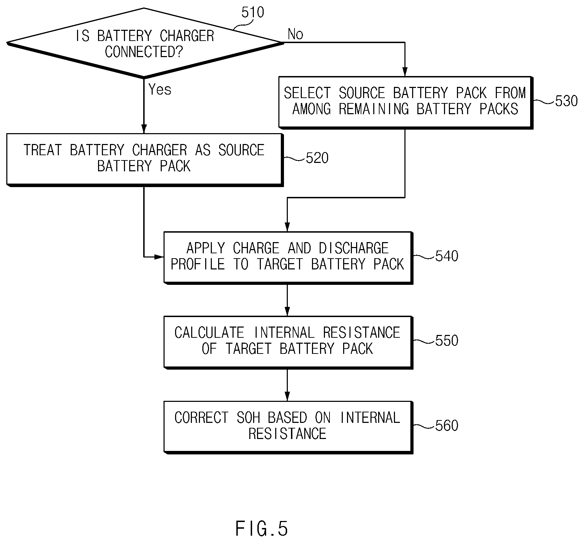

FIG. 5 illustrates a process of selecting a source battery pack and calculating internal resistance according to some embodiments.

Referring to FIG. 5, a flow 500 illustrating a process of selecting the source battery pack and calculating the internal resistance may be illustrated.

In step 510, it may be determined whether a battery charger is connected to the multi-pack battery 110. When the battery charger is connected, the battery charger may be treated as a source battery pack providing charge and discharge input in step 520. When the battery charger is not connected, the source battery pack may be selected based on battery data from among the remaining battery packs excluding the target battery pack and the auxiliary battery pack.

In step 540, the source battery pack or the battery charger may provide a constant voltage/current value as a charge and discharge input, and the charge and discharge input may be distributed to the target battery pack and the auxiliary battery pack through switching control, etc. to generate a charge and discharge profile that gradually increases or decreases. In step 550, an internal resistance value may be calculated based on an electrical response of a target battery pack to the charge and discharge profile. In step 560, the SOH or other battery index values may be updated or corrected to the latest value based on the internal resistance value.

FIG. 6 illustrates a method of applying a charge current profile to a target battery pack using an auxiliary battery pack according to some embodiments.

Referring to FIG. 6, a graph 610 representing a charge current provided by a battery charger external to the multi-pack battery 110 and a graph 620 representing a form in which the charge current is distributed to a charge current profile 621 and an auxiliary current profile 622 may be illustrated.

As in the graph 610, the charge current provided by the battery charger external to the multi-pack battery 110 may have a constant current value. Therefore, unlike the case of measuring the internal resistance of a single battery pack, the battery charger may not directly generate a specific current pattern such as the charge current profile 621.

As in the graph 620, the charge current provided by the battery charger may be distributed to the charge current profile 621 and the auxiliary current profile 622. For example, only the charging current profile 621 among the charging currents of a constant value may be provided to the target battery pack by using current distribution through switching control, etc. The auxiliary current profile 622 may be provided to the auxiliary battery pack.

FIG. 7 illustrates a method of applying a discharge current profile to a target battery pack by using an auxiliary battery pack according to some embodiments.

Referring to FIG. 7, a graph 710 representing a discharge current provided by a battery charger external to the multi-pack battery 110 and a graph 720 representing a form in which the discharge current is distributed to a discharge current profile 722 and an auxiliary current profile 721 may be illustrated.

Except that the charge and discharge input provided by the battery charger is a discharge current rather than a charge current, the description of the graph 610 and the graph 620 of FIG. 6 may be applied in a similar manner to the graph 710 and the graph 720 of FIG. 7. Meanwhile, the internal resistance of the target battery pack may be calculated based on a response voltage profile to the charge current profile 621 and/or a response voltage profile to the discharge current profile 722.

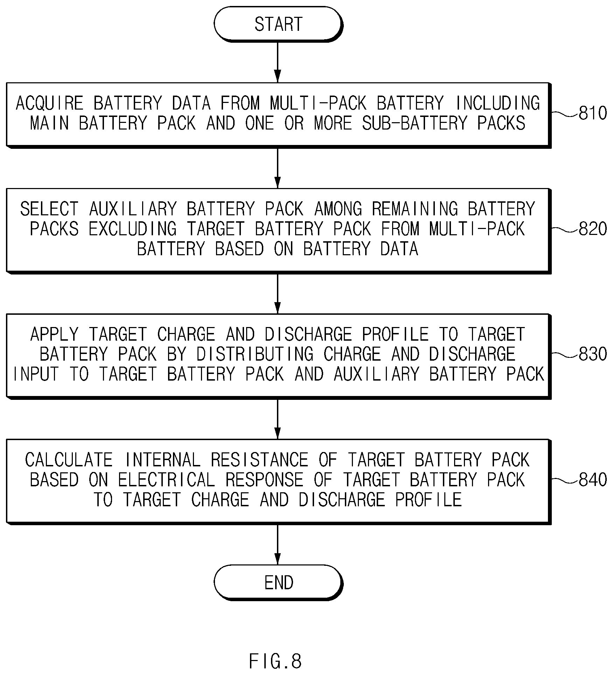

FIG. 8 illustrates steps constituting a battery management method according to some embodiments.

Referring to FIG. 8, a battery management method 800 may include steps 810 to 840. However, the present invention is not limited thereto, and some steps may be omitted or other general steps may be added, and the steps of the battery management method 800 may be executed in a different order from the illustrated order.

The battery management method 800 may be composed of steps that are processed in time series in the battery management device 120. Therefore, even if the content is omitted below, the content described above for the battery management device 120 may be equally applied to the battery management method 800.

The steps 810 to 840 of the battery management method 800 may be performed by the data acquisition unit 121 and the control unit 122 of the battery management device 120.

In step 810, the battery management device 120 may perform a step of acquiring battery data from a multi-pack battery including a main battery pack and one or more sub-battery packs.

In step 820, the battery management device 120 may perform a step of selecting an auxiliary battery pack among the remaining battery packs excluding the target battery pack from the multi-pack battery based on battery data.

In step 830, the battery management device 120 may perform a step of applying a target charge and discharge profile to the target battery pack by distributing charge and discharge input to the target battery pack and the auxiliary battery pack.

In step 840, the battery management device 120 may perform a step of calculating an internal resistance of the target battery pack based on an electrical response of the target battery pack to the target charge and discharge profile.

According to the embodiment, the battery management method 800 may be implemented in the form of a computer program stored in a computer-readable storage medium. That is, the computer program may include instructions for implementing the battery management method 800, and the instructions of the program may be stored in the computer-readable storage medium. The computer program may include a mobile application.

According to the embodiment, the computer-readable storage medium may include magnetic media such as hard disks, floppy disks, and magnetic tapes, optical media such as CD-ROMs, DVDs, magneto-optical media such as floptical disks, and hardware devices specifically configured to store and execute computer program instructions such as ROMs, RAMs, flash memory, etc. The computer program instructions may include machine language codes produced by a compiler and high-level language codes executable by a computer using an interpreter, etc.

The terms "include," "configure," or "have" described above, unless specifically stated to the contrary, mean that the corresponding component may be included, and therefore should be interpreted as further including other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above description is merely an illustrative description of the technical idea disclosed in this document, and a person skilled in the art to which the embodiments disclosed in this document belong may make various modifications and variations thereto without departing from the essential characteristics of the embodiments disclosed in this document. Therefore, the embodiments disclosed in this document are not intended to limit the technical idea of the embodiments disclosed in this document, but rather to explain it, and the scope of the technical idea disclosed in this document is not limited by these embodiments. The scope of protection of the technical idea disclosed in this document should be interpreted by the claims below, and all technical ideas within the equivalent scope should be interpreted as being included in the scope of the rights of this document.

### [Description of symbols]

100: battery management system 110: multi-pack battery
111: traction battery 112a to 112n: one or more extender batteries
120: battery management unit 121: data acquisition unit
122: control unit

## Claims

1. A battery management device comprising:
a data acquisition unit configured to acquire battery data from a multi-pack battery including a main battery pack and one or more sub-battery packs; and
a control unit configured to:
select an auxiliary battery pack among the remaining battery packs excluding a target battery pack from the multi-pack battery based on the battery data;
apply a target charge and discharge profile to the target battery pack by distributing charge and discharge input to the target battery pack and the auxiliary battery pack; and
calculate an internal resistance of the target battery pack based on an electrical response of the target battery pack to the target charge and discharge profile.

2. The battery management device of claim 1, wherein the control unit is configured to:
generate a charge current profile for the target battery pack by distributing a charge current to the target battery pack and the auxiliary battery pack; and
generate a discharge current profile for the target battery pack by distributing a discharge current to the target battery pack and the auxiliary battery pack.

3. The battery management device of claim 1, wherein the control unit is configured to generate the charge and discharge input based on whether a battery charger is connected to the multi-pack battery.

4. The battery management device of claim 3, wherein the control unit is configured to generate the charge and discharge input based on a charge and discharge of the battery charger when the battery charger is connected to the multi-pack battery.

5. The battery management device of claim 3, wherein the control unit is configured to:
select a source battery pack among the remaining battery packs excluding the target battery pack and the auxiliary battery pack from the multi-pack battery based on the battery data when the battery charger is not connected to the multi-pack battery; and
generate the charge and discharge input based on the charge and discharge of the source battery pack.

6. The battery management device of claim 1, wherein the control unit is further configured to correct a state of health (SOH) of the target battery pack based on the internal resistance.

7. The battery management device of claim 1, wherein the control unit is configured to:
initiate a calculation process of the internal resistance when there is a user manual setting;
transmit a suggestion message to the user terminal based on a timer regarding an unused time of the multi-pack battery when there is no user manual setting; and
initiate a calculation process of the internal resistance when there is a user agreement on the suggestion message.

8. A battery management method comprising:
acquiring battery data from a multi-pack battery including a main battery pack and one or more sub-battery packs;
selecting an auxiliary battery pack among the remaining battery packs excluding a target battery pack from the multi-pack battery based on the battery data;
applying a target charge and discharge profile to the target battery pack by distributing charge and discharge input to the target battery pack and the auxiliary battery pack; and
calculating an internal resistance of the target battery pack based on an electrical response of the target battery pack to the target charge and discharge profile.

9. The battery management method of claim 8, wherein the applying of the target charge and discharge profile includes:
generating a charge current profile for the target battery pack by distributing a charge current to the target battery pack and the auxiliary battery pack; and
generating a discharge current profile for the target battery pack by distributing a discharge current to the target battery pack and the auxiliary battery pack.

10. The battery management method of claim 8, wherein the applying of the target charge and discharge profile includes generating the charge and discharge input based on whether a battery charger is connected to the multi-pack battery.

11. The battery management method of claim 10, wherein the applying of the target charge and discharge profile includes generating the charge and discharge input based on a charge and discharge of the battery charger when the battery charger is connected to the multi-pack battery.

12. The battery management method of claim 10, wherein the applying of the target charge and discharge profile includes:
selecting a source battery pack among the remaining battery packs excluding the target battery pack and the auxiliary battery pack from the multi-pack battery based on the battery data when the battery charger is not connected to the multi-pack battery; and
generating the charge and discharge input based on the charge and discharge of the source battery pack.

13. The battery management method of claim 8, further comprising:
correcting a state of health (SOH) of the target battery pack based on the internal resistance.

14. The battery management method of claim 8, wherein the calculating of the internal resistance includes:
initiating a calculation process of the internal resistance when there is a user manual setting;
transmitting a suggestion message to the user terminal based on a timer regarding an unused time of the multi-pack battery when there is no user manual setting; and
initiating a calculation process of the internal resistance when there is a user agreement on the suggestion message.
